# EUROPÄISCHE PATENTANMELDUNG

(11) **EP 3 016 485 A2**
(43) Veröffentlichungstag der Anmeldung: **04.05.2016**
(21) Anmeldenummer: 15183432.2
(22) Anmeldetag: 02.09.2015
(51) Int. Cl.: H05K 1/14, H05K 1/18, H05K 3/28, H05K 3/36

(54) **ELEKTRISCHES GERÄT FÜR DEN EINSATZ IN EINEM KONTAMINIERENDEN MEDIUM UND VERFAHREN ZUR HERSTELLUNG EINES SOLCHEN**

(30) Priorität: 28.10.2014 DE 102014221973
(71) Anmelder: ROBERT BOSCH GMBH, 70442 Stuttgart (DE)
(72) Erfinder: Gerhaeusser, Martin, 74336 Brackenheim-Stockheim (DE)

(57) **Zusammenfassung**

Die Erfindung betrifft ein elektrisches Gerät 1 für den Einsatz in einem kontaminierenden Medium, mit einem Leiterbahnsubstrat 2, das auf wenigstens einer Oberfläche 21 des Leiterbahnsubstrats 2 wenigstens eine elektrische Kontaktfläche 22 aufweist, und mit einer Schutzfolie 3, welche an dem Gerät 1 derart angeordnet ist, dass die wenigstens eine elektrische Kontaktfläche 22 zwischen der Schutzfolie 3 und dem Leiterbahnsubstrat 2 vor dem kontaminierenden Medium geschützt angeordnet ist. Es wird vorgeschlagen, dass die Schutzfolie 3 durch eine flexible Leiterbahnfolie 30 gebildet wird, die wenigstens eine dem Leiterbahnsubstrat 2 zuweisende elektrische Anschlussfläche 36 aufweist, die mit der wenigstens einen elektrischen Kontaktfläche 22 elektrisch leitend verbunden ist. Ferner betrifft die Erfindung ein Verfahren zur Herstellung eines solchen Gerätes.

## Beschreibung

### Stand der Technik

Die Erfindung betrifft ein elektrisches Gerät für den Einsatz in einem kontaminierenden Medium und ein Verfahren zur Herstellung eines solchen Gerätes.

Es ist bekannt, in der Kraftfahrzeugtechnik elektrische Geräte für den Einsatz in Hydraulikfluid eines Kraftfahrzeuggetriebes zu verwenden. Solche elektrischen Geräte können beispielsweise elektrische Steuergeräte oder Sensormodule sein, die am Getriebe und im Getriebefluid eingesetzt werden können. Die Steuergeräte, die auch als Steuermodule bezeichnet werden, können beispielsweise elektrische Bauelemente wie Stecker, Sensoren, Aktuatoren, eine elektronische Schaltung (TCU, Transmission Control Unit) und gegebenenfalls weitere Komponenten aufweisen. Sensormodule weisen mehrere auf einem Träger angeordnete Sensoren auf. Die Anordnung im Getriebefluid stellt hohe Herausforderungen an den Gesamtaufbau des elektrischen Gerätes, da die Komponenten und elektrischen Verbindungen vor dem kontaminierenden Getriebefluid mit darin gegebenenfalls enthaltenen Metallspänen geschützte werden müssen.

Aus der EP 0 508 286 B1 ist ein elektrisches Gerät für den Einsatz in einem kontaminierenden Medium bekannt, das eine auf einer Metallplatte angeordnete Leiterplatte aufweist. Die Leiterplatte weist auf wenigstens einer Oberfläche elektrische Kontaktflächen auf, an denen Elektronikbauteile mit der Leiterplatte elektrisch verbunden sind. Eine Schutzfolie ist über der Leiterplatte angeordnet und in einem Randbereich auf die Metallplatte luft- und wasserdicht aufgeklebt, so dass die elektrischen Kontaktflächen zwischen der Schutzfolie und der Leiterplatte vor einem kontaminierenden Medium geschützt sind. Zusätzlich ist zum mechanischen Schutz ein Gehäusedeckel auf die Metallplatte aufgesetzt.

Aus der DE 10 2006 045 896 A1 ist ein Elektronikgehäuse zur Aufnahme einer elektronischen oder mechatronischen Vorrichtung bekannt. Auf einem Gehäuseboden ist eine elektronische Vorrichtung angeordnet, die mittels Leiterbahnen elektrisch mit einem Leiterbahnträger gekoppelt ist. Mittels eines Klebstoffs ist zum Schutz der elektronischen Vorrichtung und der Anschlussstellen an den Leiterbahnträger ein flexibler Schutzdeckel auf den Gehäuseboden und den Leiterbahnträger aufgeklebt. Der flexible Schutzdeckel weist eine Metallfolie zum Schutz vor elektromagnetischer Strahlung auf.

Weiterhin ist aus der DE 10 2010 030 063 A1 eine Anordnung bekannt, bei der ein Leiterbahnträger auf eine Metallplatte aufgeklebt ist. Ein elektronisches Bauelement ist in einer Aussparung des Leiterbahnträgers auf der Metallplatte angeordnet und mit Kontaktflächen des Leiterbahnträgers elektrisch kontaktiert. Die Kontaktstellen des Bauelements mit dem Leiterbahnträger sind durch ein Deckelteil geschützt, das über den Kontaktstellen auf den Leiterbahnträger und das Bauelement aufgeklebt ist.

Aus der DE 102 24 266 A1 ist eine elektrische Verbindung einer starren Leiterplatte mit einer flexiblen Leiterbahnfolie bekannt. Die mit Bauelementen versehene Leiterplatte weist in ihrem Randbereich eine mit Lot beschichtete Kontaktfläche auf, auf welche die Anschlussfläche einer flexiblen Leiterbahnfolie aufgelötet ist.

### Offenbarung der Erfindung

Die Erfindung betrifft ein elektrisches Gerät für den Einsatz in einem kontaminierenden Medium, mit einem Leiterbahnsubstrat, das auf wenigstens einer Oberfläche wenigstens eine elektrische Kontaktfläche aufweist, und mit einer Schutzfolie, welche an dem Gerät derart angeordnet ist, dass die wenigstens eine elektrische Kontaktfläche zwischen der Schutzfolie und der dem Leiterbahnsubstrat vor dem kontaminierenden Medium geschützt angeordnet ist.

Erfindungsgemäß wird vorgeschlagen, dass die Schutzfolie durch eine flexible Leiterbahnfolie gebildet wird, die wenigstens eine dem Leiterbahnsubstrat zuweisende elektrische Anschlussfläche aufweist, die mit der wenigstens einen Kontaktfläche elektrisch leitend verbunden ist. Weiterhin betrifft die Erfindung ein Verfahren zu Herstellung eines solchen elektrischen Gerätes.

### Vorteile der Erfindung

Bei dem aus dem Stand der Technik bekannten elektrischen Geräten wird entweder eine flexible Schutzfolie zum Schutz von Kontaktstellen eines Leiterbahnsubstrats eingesetzt oder aber es werden flexible Leiterbahnfolien zur elektrischen Anbindung an eine Kontaktstelle eines Leiterbahnsubstrats eingesetzt. Es ist aber kein elektrisches Gerät bekannt, bei dem eine flexible Leiterbahnfolie gleichzeitig zum Schutz wenigstens einer Kontaktfläche des Leiterbahnsubsubstrats und zur elektrischen Anbindung an das Leiterbahnsubstrat verwandt wird.

Das erfindungsgemäße Gerät hat den Vorteil, dass eine flexible Leiterbahnfolie eingesetzt wird, um wenigstens eine auf der Oberfläche des Leiterbahnsubstrats angeordnete Kontaktfläche vor einem kontaminierenden Medium, wie beispielsweise Getriebefluid zu schützen. Außerdem ist die flexible Leiterbahnfolie auch elektrisch mit der Kontaktfläche verbunden, so dass mittels der flexiblen Leiterbahnfolie zusätzlich elektrische Baukomponenten an das Leiterbahnsubstrat angeschlossen werden können. Der flexiblen Leiterbahnfolie kommt somit eine Doppelfunktion zu, einerseits als elektrischer Verbindungsträger und andererseits als Schutzfolie von elektrischen Kontaktstellen und Bauelementen, die zwischen der Leiterbahnfolie und dem Leiterbahnsubstrat angeordnet sind.

Die geringe Materialstärke der flexiblen Leiterbahnfolie ermöglicht eine sehr kompakte Bauweise. Durch den reduzierten Materialeinsatz ergeben sich Kostenvorteile und Gewichtsvorteile. Durch das verringerte Gewicht können auch Beschleunigungskräfte reduziert werden, welche im Betrieb auf das elektrische Gerät und die darauf angeordneten Komponenten wirken. Daher können Stützteile und Befestigungsvorrichtungen eingespart werden, welche sonst eingesetzt werden müssten, um die Beschleunigungskräfte abzustützen.

Vorteilhafte Ausführungsformen und Weiterbildungen der Erfindung werden durch die in den abhängigen Ansprüchen genannten Merkmale ermöglicht.

Vorteilhaft kann die flexible Leiterbahnfolie zum Schutz der wenigstens einen elektrischen Kontaktfläche in einem umlaufenden Bereich um die Kontaktfläche an der Oberfläche des Leiterbahnsubstrats festgelegt sein. Beispielsweise kann die flexible Leiterbahnfolie in dem umlaufenden Bereich auf die Oberfläche des Leiterbahnsubstrats aufgeklebt sein. Dadurch entsteht zwischen der flexiblen Leiterbahnfolie und dem Leiterbahnsubstrat ein geschützter Raum, in dem die wenigstens eine Kontaktstelle geschützt angeordnet ist. Es können eine oder gleichzeitig mehrere Kontaktflächen in diesem Raum angeordnet sein.

Vorteilhaft erfolgt die elektrische Verbindung zwischen der wenigstens einen elektrischen Anschlussfläche der flexiblen Leiterbahnfolie und der wenigstens einen Kontaktfläche durch eine Lötung. Die Kontaktfläche des Leiterbahnsubstrats kann in einfacher Weise mit Lot beschichtet werden. Die auf die mit Lot versehen Kontaktfläche aufgesetzte Anschlussfläche kann dann beispielsweise mittels einer Thermode mit der Kontaktfläche verlötet werden.

Die flexible Leiterbahnfolie weist eine Leiterbahnlage mit wenigstens einer elektrischen Leiterbahn auf, die mittels einer ersten Klebeschicht auf eine Trägerfolie aufgeklebt ist, sowie eine Deckfolie, die mittels einer zweiten Klebeschicht auf die von der Trägerfolie abgewandte Seite der Leiterbahn aufgeklebt ist. Vorteilhaft ist ein Abschnitt der flexiblen Leiterbahnfolie im Bereich der wenigstens einen Kontaktfläche des Leiterbahnsubstrats vor der Abdeckung mittels der Trägerfolie und der ersten Klebeschicht ausgenommen, so dass ein Teil der wenigstens eine Leiterbahn freiliegt. Dieser Teil bildet vorteilhaft die wenigstens eine Anschlussfläche, welche mit der wenigstens einen Kontaktfläche des Leiterbahnsubstrats elektrisch kontaktiert werden kann. Die zweite Klebeschicht und die Deckfolie können dann vorteilhaft einen seitlich über die Kontaktfläche überstehenden Befestigungsabschnitt bilden, der mittels der zweiten Klebeschicht auf die Oberfläche des Leiterbahnsubstrats aufgeklebt werden kann. Dadurch ist ein umlaufender Dichtbereich um die wenigstens eine Kontaktfläche oder auch um mehrere Kontaktfläche auf der Oberfläche des Leiterbahnsubstrats in einfacher Weise darstellbar.

Vorteilhaft kann weiterhin wenigstens eine elektrische Baukomponente des elektrischen Geräts innerhalb eines geschützten Bereichs zwischen der flexiblen Leiterbahnfolie und dem Leiterbahnsubstrat angeordnet sein und mittels der flexiblen Leiterbahnfolie mit der wenigstens einen Kontaktfläche des Leiterbahnsubstrats elektrisch kontaktiert werden.

In einem Ausführungsbeispiel ist es zur Verbesserung der Wärmeableitung möglich, dass die wenigstens eine elektrische Baukomponente in einer Aussparung des Leiterbahnsubstrats auf einer insbesondere metallischen Trägerplatte angeordnet wird, auf oder an der auch das Leiterbahnsubstrat angeordnet ist.

Vorteilhaft ist weiterhin ein Verfahren zum Herstellen eines solchen elektrischen Gerätes mit folgenden Schritten:
- Bereitstellen eines Leiterbahnsubstrats, das auf wenigstens einer Oberfläche des Leiterbahnsubstrats wenigstens eine mit einem Lot beschichtete, elektrische Kontaktfläche aufweist,
- Bereitstellen einer durch eine flexible Leiterbahnfolie gebildeten Schutzfolie,
- Anordnen der flexiblen Leiterbahnfolie an dem Gerät, so dass die wenigstens eine elektrische Kontaktfläche zwischen der flexiblen Leiterbahnfolie und dem Leiterbahnsubstrat angeordnet ist und eine elektrische Anschlussfläche der flexiblen Leiterbahnfolie an der mit Lot versehenen wenigstens einen elektrischen Kontaktfläche zur Anlage gelangt,
- Verlöten der elektrischen Anschlussfläche mit der wenigstens einen elektrischen Kontaktfläche und
- vor, während oder nach dem Schritt des Verlötens, Festlegen der flexiblen Leiterbahnfolie, insbesondere Aufkleben in einem umlaufenden Bereich um die wenigstens eine Kontaktfläche an der Oberfläche des Leiterbahnsubstrats.

In einfacher Weise kann die elektrische Anschlussfläche durch Wärmezufuhr durch die Deckfolie der flexiblen Leiterplatten hindurch mit der flexiblen Leiterbahnfolie verlötet werden. Vorteilhaft kann der Schritt der Verklebung zusammen mit der Montage oder der Lötung der flexiblen Leitierbahnfolie durchgeführt werden.

### Kurze Beschreibung der Zeichnungen

Es zeigen
Fig. 1 ein erstes Ausführungsbeispiel eines erfindungsgemäßen elektrischen Gerätes anhand eines schematischen Querschnitts, der nur ein Teil des Gerätes zeigt,
Fig. 2 ein zweites Ausführungsbeispiel eines erfindungsgemäßen elektrischen Gerätes anhand eines schematischen Querschnitts, der nur ein Teil des Gerätes zeigt,
Fig. 3 eine Draufsicht auf das erfindungsgemäße elektrische Gerät, bei dem eine flexible Leiterbahnfolie zum Schutz von elektrischen Kontaktflächen in einem umlaufenden Bereich um die Kontaktflächen an der Oberfläche des Leiterbahnsubstrats festgelegt ist.

### Ausführungsformen der Erfindung

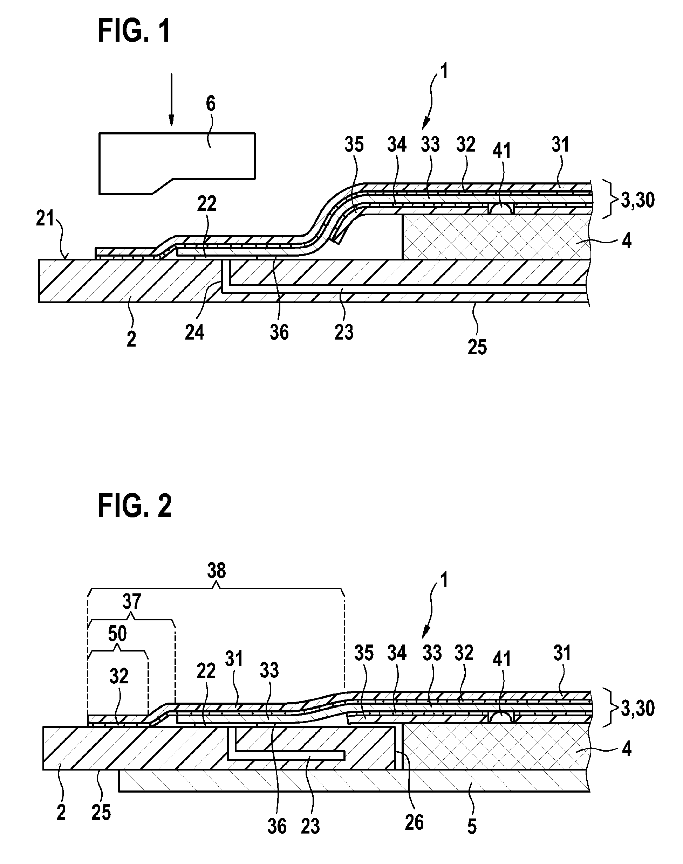

Fig. 1 zeigt einen Ausschnitt aus einem elektrischen Gerät 1. Das elektrische Gerät kann beispielsweise ein elektrisches Steuergerät, insbesondere ein Getriebesteuergerät, oder ein Sensormodul sein, die in einem Getriebe oder an einem Getriebe verbaubar sind. Es kann sich aber auch um ein anderes elektrisches Gerät handeln, das zum Einsatz in einem kontaminierenden Medium bestimmt ist.

Das elektrische Gerät 1 weist ein Leiterbahnsubstrat 2 auf. Das Leiterbahnsubstrat 2 kann eine starre Leiterplatte, insbesondere eine Multilayer-Leiterplatte, eine flexible Leiterbahnfolie (flexbile Leiterplatte bzw. FPC=flexible printed circuit board), eine starr-flexible-Leiterplatte, ein umspritztes Stanzgitter oder ein anderes Leiterbahnsubstrat sein. Hier beispielhaft dargestellt ist eine Leiterplatte, die im Inneren eine Leiterbahn 23 aufweist. Diese Leiterbahn 23 ist über eine Durchkontaktierung beziehungsweise einen Zwischenverbinder 24 mit einer Kontaktfläche 22 auf der Oberfläche 21 des Leiterbahnsubstrats verbunden. Die Kontaktfläche 22 kann in die Oberfläche 21 integriert sein oder, wie dargestellt, ein Stück davon abstehen.

An dem Leiterbahnsubstrat können elektrische Bauelemente wie Stecker, Sensoren, Aktuatoren, eine elektronische Schaltung (TCU, Transmission Control Unit) und gegebenenfalls weitere Komponenten festgelegt werden. In Fig. 1 und Fig. 2 ist nur eine Komponente dargestellt. Dabei handelt es ich um eine elektrische Baukomponente 4, beispielsweise ein elektronisches Schaltungsteil oder einen Sensor.

In Fig. 1 ist weiterhin eine Schutzfolie 3 gezeigt, die durch eine flexible Leiterbahnfolie 30 gebildet wird. Die flexible Leiterbahnfolie 30 weist wenigstens sechs Lagen auf. Auf einer mittleren Lage ist wenigstens eine Leiterbahn 33, aus beispielsweise Kupfer angeordnet. Selbstverständlich können in dieser Lage auch mehrere Leiterbahnen verlaufen. Die wenigstens eine Leiterbahn 33 beziehungsweise die mit der Leiterbahn 33 versehene innere Lage ist über eine erste Klebeschicht 34 auf eine Trägerfolie 35 aufgebracht. Die Trägerfolie 35 besteht aus einer isolierenden Folie. Über der Leiterbahn 33 ist mittels einer zweiten Klebeschicht 32 eine Deckfolie 31 aufgeklebt. Die Deckfolie besteht ebenfalls aus isolierendem Material. Derartige flexible Leiterbahnfolien sind im Stand der Technik bekannt.

In einem Abschnitt 38, der in Fig. 2 gezeigt ist, kann die flexible Leiterbahnfolie 30 nicht mit der Trägerfolie 35 und der ersten Klebeschicht 34 versehen sein, so dass der frei liegende Teil der wenigstens einen Leiterbahn 33 eine Anschlussfläche 36 bildet. Der Abschnitt 38 kann beispielsweise ein Randbereich der flexiblen Leiterbahnfolie 30 sein. Die flexible Leiterbahnfolie 30 wird so auf die Oberfläche 21 des Leiterbahnsubstrats 2 aufgelegt, dass die Anschlussfläche 36 auf der Kontaktfläche 22 zur Anlage gelangt. Zur Herstellung einer elektrischen Verbindung kann die Kontaktfläche 22 mit Lot beschichtet sein. Alternativ kann auch ein Leitkleber oder eine andere geeignete elektrische Kontaktierungsweise verwandt werden.

Weiterhin ist die flexible Leiterbahnfolie so ausgestaltet, dass die zweite Klebeschicht 32 und die Deckfolie 31 einen seitlich über die Kontaktfläche 22 und die Anschlussfläche 36 überstehenden Befestigungsabschnitt 37 bilden, der mittels der zweiten Klebeschicht 32 auf die Oberfläche 21 des Leiterbahnsubstrats 2 aufgeklebt ist.

Wie dargestellt kann eine Thermode 6 verwandt werden, die im Befestigungsbereich 38 auf die flexible Leiterbahnfolie abgesenkt wird. Durch Wärmezufuhr über die Thermode wird das Lot auf der Kontaktfläche 22 aufgeschmolzen und die Kontaktfläche 22 mit der Anschlussfläche 36 verlötet. Die Thermode kann vorteilhaft auch zum Aufpressen der zweiten Klebeschicht 34 im Bereich des Befestigungsabschnitts 37 auf die Oberfläche 21 des Leiterbahnsubstrats 2 verwandt werden. Der Klebeschritt kann aber auch vor oder nach dem Löten durchgeführt werden.

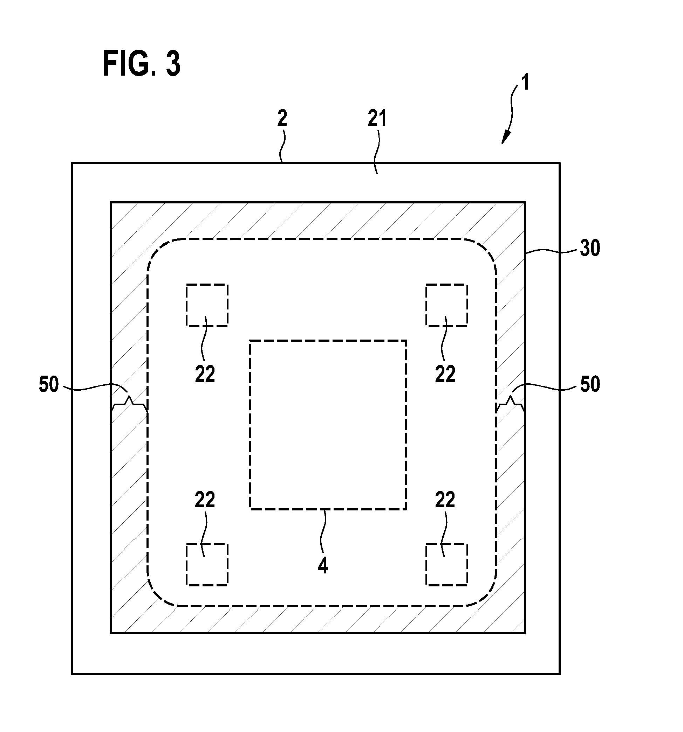

Der mittels der zweiten Klebeschicht 32 auf die Oberfläche 21 des Leiterbahnsubstrats 2 aufgeklebte Abschnitt der flexiblen Leiterbahnfolie bildet einen in Fig. 2 und Fig. 3 dargestellten umlaufenden Bereich 50. Der umlaufende Bereich 50 ist dabei umlaufend um die wenigstens eine Kontaktfläche 22 ausgebildet. Wie am besten in Fig. 3 zu erkennen ist, braucht der umlaufende Bereich 50 seitlich nicht überall gleich weit von einer Kontaktfläche 22 beabstandet zu sein. Es ist insbesondere möglich, den umlaufenden Bereich so zu wählen, dass eine Kontaktfläche 22 an der seinen Seite eng und an den anderen Seiten großräumig umlaufen wird oder dass sich mehrere Kontaktflächen 22 innerhalb des umlaufenden Bereichs 50 befinden, wie dies in Fig. 3 gut zu erkennen ist. Im Querschnitt der Fig. 1 und der Fig. 2 ist der rechte Teil des elektrischen Geräts nicht zu erkennen. Es versteht sich, dass dort der umlaufende Abschnitt 50 ebenfalls vorhanden ist. Abweichend von den dargestellten Ausführungsbeispielen ist es aber auch möglich, dass der umlaufende Bereich 50 an allen Seiten direkt benachbart zu der wenigstens einen Kontaktfläche 22 ausgestaltet ist. Unter einen umlaufenden Bereich 50 um die wenigstens Kontaktfläche 22 ist im Kontext der Anmeldung also ein Bereich zu verstehen, der einer beliebigen umlaufenden Linie folgt, welche die Kontaktfläche in der Ebene der Oberfläche 21 vollständig umgibt.

Durch das umlaufende Aufkleben der flexiblen Leiterbahnfolie 30 auf das Leiterbahnsubstrat 2 entsteht zwischen der flexiblen Leiterbahnfolie 30 und dem Leiterbahnsubstrat 2 ein vor kontaminierenden Medien geschützter Raum. In diesem Raum sind die Kontaktfläche 22 und die elektrische Verbindungsstelle von Anschlussfläche 36 und Kontaktfläche 22 geschützt angeordnet. Wie in Fig. 1 und Fig. 2 zu erkennen ist, ist die Kontaktfläche 22 durch das Leiterbahnsubstrat 2 und die flexible Leiterbahnfolie 30 geschützt. Das kontaminierende Medium kann auch seitlich nicht durch den umlaufenden Bereich 50 hindurch bis zur Kontaktfläche 22 vordringen. Auf diese Weise werden durch die spaltfreie Klebung leitende Partikel im kontaminierenden Medium, beispielsweise Metallspäne des Getriebes, von der elektrischen Kontaktstelle zwischen der Kontaktfläche 22 und der Anschlussfläche 36 abgehalten.

Die flexible Leiterbahnfolie 30 kann mit Baukomponenten elektrisch verbunden sein. Wie in Fig. 1 dargestellt ist, kann beispielsweise eine elektrische Baukomponente 4, beispielsweise eine TCU mit Anschlüssen 41, ein Halbleiterbauelement, ein Widerstandsbauelement oder irgendeine andere elektrische und/oder elektronische Baukomponente beispielsweise mittels Anschlüssen 41, welche die Trägerfolie 34 und die erste Klebeschicht 34 durchdringen, mit der Leiterbahn 33 der flexiblen Leiterbahnfolie 30 elektrisch verbunden sein. Wie in Fig. 1, Fig. 2 und Fig. 3 dargestellt ist, befindet sich die elektrische Baukomponente 4 ebenfalls in dem geschützten Raum zwischen der flexiblen Leiterbahnfolie 30 und dem Leiterbahnsubstrat 2. Die elektrische Baukomponente 4 ist auf die Oberfläche 21 des Leiterbahnsubstrats 2 aufgelegt und kann mittels eines Klebers auch mit dem Leiterbahnsubstrat 2 verbunden sein. Als Träger der elektrischen Verbindungen dient in diesem Ausführungsbeispiel die flexible Leiterbahnfolie 30, auf welcher die elektrische Baukomponente beispielsweise mittels der Anschlüsse 41 aufgelötet sein kann. Die flexible Leiterbahnfolie 30 in den Figuren 1 bis 3 dient somit einerseits dem Schutz der elektrischen Baukomponente 4 als auch andererseits zu deren elektrischer Verbindung mit dem Leiterbahnsubstrat 2.

Bei dem Ausführungsbeispiel der Fig. 2 ist die elektrische Baukomponente 4 in einer Aussparung 26 des Leiterbahnsubstrats 2 auf eine Trägerplatte 5, beispielsweise eine Metallplatte aus Aluminium oder einem anderen Metall aufgebracht. Die Metallplatte 4 dient der Wärmeabfuhr und nimmt die von der elektrischen Baukomponente 4 erzeugte Wärme auf und führt diese ab. Auch in diesem Ausführungsbeispiel ist die Baukomponente 4 zwischen der flexiblen Leiterbahnfolie 30 und dem Leiterbahnsubstrat 2 geschützt angeordnet. Die Formulierung "zwischen der der flexiblen Leiterbahnfolie 30 und dem Leiterbahnsubstrat 2" soll im Kontext der Anmeldung ausdrücklich auch die Anordnung in einer Aussparung des Leiterbahnsubstrats mit umfassen, bei der die Baukomponente 4 bis zur Unterseite 25 des Leiterbahnsubstrats 2 hindurch ragt. Die Metallplatte 5 ist hier quasi als ein Verbundteil des Leiterbahnsubstrats anzusehen, dass die Aussparung 26 auf der Unterseite 25 des Leiterbahnsubstrats 2 abdeckt.

Fig. 3 zeigt eine Draufsicht auf das erfindungsgemäße elektrische Gerät aus Fig. 1 oder Fig. 2. Die flexible Leiterbahnfolie 30 deckt ein Großteil der Oberfläche 21 des Leiterbahnsubstrats 2 ab und ist in dem umlaufenden Bereich 50 auf die Oberfläche 21 aufgeklebt. Unter der flexiblen Leiterbahnfolie 30 sind durch gepunktete Linien vier Kontaktflächen 22 und eine elektrische Baukomponente 4 dargestellt, die zwischen der Leiterbahnfolie 30 und dem Leiterbahnsubstrat 2 geschützt angeordnet sind.

## Patentansprüche

1. Elektrisches Gerät (1) für den Einsatz in einem kontaminierenden Medium, mit einem Leiterbahnsubstrat (2), das auf wenigstens einer Oberfläche (21) des Leiterbahnsubstrats (2) wenigstens eine elektrische Kontaktfläche (22) aufweist, und mit einer Schutzfolie (3), welche an dem Gerät (1) derart angeordnet ist, dass die wenigstens eine elektrische Kontaktfläche (22) zwischen der Schutzfolie (3) und dem Leiterbahnsubstrat (2) vor dem kontaminierenden Medium geschützt angeordnet ist, **dadurch gekennzeichnet, dass** die Schutzfolie (3) durch eine flexible Leiterbahnfolie (30) gebildet wird, die wenigstens eine dem Leiterbahnsubstrat (2) zuweisende elektrische Anschlussfläche (36) aufweist, die mit der wenigstens einen elektrischen Kontaktfläche (22) elektrisch leitend verbunden ist.

2. Elektrisches Gerät nach Anspruch 1, **dadurch gekennzeichnet, dass** die flexible Leiterbahnfolie (30) zum Schutz der wenigstens einen elektrischen Kontaktfläche (22) in einem umlaufenden Bereich (50) um die Kontaktfläche (22) an der Oberfläche (21) des Leiterbahnsubstrats (2) festgelegt ist.

3. Elektrisches Gerät nach Anspruch 2, **dadurch gekennzeichnet, dass** die flexible Leiterbahnfolie (30) in dem umlaufenden Bereich (50) auf die Oberfläche (21) des Leiterbahnsubstrats (2) aufgeklebt ist.

4. Elektrisches Gerät nach einem der vorstehenden Ansprüche, **dadurch gekennzeichnet, dass** die wenigstens eine elektrische Anschlussfläche (36) der flexiblen Leiterbahnfolie (30) auf die wenigstens eine Kontaktfläche (22) aufgelötet ist.

5. Elektrisches Gerät nach einem der vorstehenden Ansprüche, **dadurch gekennzeichnet, dass** die flexible Leiterbahnfolie (30) wenigstens eine elektrische Leiterbahn (33) aufweist, die mittels einer ersten Klebeschicht (34) auf eine Trägerfolie (35) aufgeklebt ist, sowie eine Deckfolie (31), die mittels einer zweiten Klebeschicht (32) auf die von der Trägerfolie (35) abgewandte Seite der Leiterbahn (33) aufgeklebt ist.

6. Elektrisches Gerät nach Anspruch 5, **dadurch gekennzeichnet, dass** ein Abschnitt (38) der flexiblen Leiterbahnfolie (30) im Bereich der wenigstens einen Kontaktfläche (22) des Leiterbahnsubstrats (2) nicht mit der Trägerfolie (35) und der ersten Klebeschicht (34) versehen ist, so dass ein frei liegender Teil der wenigstens einen Leiterbahn (33) die Anschlussfläche (36) bildet, die mit der wenigstens einen Kontaktfläche (22) elektrisch kontaktiert ist, und dass die zweite Klebeschicht (32) und die Deckfolie (31) einen seitlich über die Kontaktfläche (22) überstehenden Befestigungsabschnitt (37) bilden, der mittels der zweiten Klebeschicht (32) auf die Oberfläche (21) des Leiterbahnsubstrats (2) aufgeklebt ist.

7. Elektrisches Gerät nach einem der vorstehenden Ansprüche, **dadurch gekennzeichnet, dass** wenigstens eine elektrische Baukomponente (4) des elektrischen Geräts (1) innerhalb eines geschützten Bereichs zwischen der flexiblen Leiterbahnfolie (30) und dem Leiterbahnsubstrat (2) angeordnet ist und mittels der flexiblen Leiterbahnfolie (30) mit der wenigstens einen Kontaktfläche (22) des Leiterbahnsubstrats (2) elektrisch kontaktiert ist.

8. Elektrisches Gerät nach Anspruch 7, **dadurch gekennzeichnet, dass** die wenigstens eine elektrische Baukomponente (4) in einer Aussparung (26) des Leiterbahnsubstrats (26) auf einer Trägerplatte (5) angeordnet ist, wobei auf der Trägerplatte (5) oder an der Trägerplatte (5) das Leiterbahnsubstrat (2) angeordnet ist.

9. Elektrisches Gerät nach einem der vorstehenden Ansprüche, **dadurch gekennzeichnet, dass** das elektrische Gerät (1) ein elektrisches Getriebesteuermodul oder ein Sensormodul ist, das in einem Getriebe oder an einem Getriebe verbaubar ist.

10. Verfahren zum Herstellen eines elektrischen Gerätes (1) nach Anspruch 1, **gekennzeichnet durch** folgende Schritte:
- Bereitstellen eines Leiterbahnsubstrats (2), das auf wenigstens einer Oberfläche (21) des Leiterbahnsubstrats (2) wenigstens eine mit einem Lot beschichtete, elektrische Kontaktfläche (22) aufweist,
- Bereitstellen einer **durch** eine flexible Leiterbahnfolie (30) gebildeten Schutzfolie (3),
- Anordnen der flexiblen Leiterbahnfolie (30) an dem Gerät (1), so dass die wenigstens eine elektrische Kontaktfläche (22) zwischen der flexiblen Leiterbahnfolie (30) und dem Leiterbahnsubstrat (2) angeordnet ist und eine elektrische Anschlussfläche (36) der flexiblen Leiterbahnfolie (30) an der mit Lot versehenen wenigstens einen elektrischen Kontaktfläche (22) zur Anlage gelangt,
- Verlöten der elektrischen Anschlussfläche (36) mit der wenigstens einen elektrischen Kontaktfläche (22) und
- vor, während oder nach dem Schritt des Verlötens, Festlegen der flexiblen Leiterbahnfolie (30), insbesondere Aufkleben in einem umlaufenden Bereich (50) um die wenigstens eine Kontaktfläche (22) an der Oberfläche (21) des Leiterbahnsubstrats (2).
